# EUROPÄISCHE PATENTANMELDUNG

(11) **EP 1 381 074 A2**
(43) Veröffentlichungstag der Anmeldung: **14.01.2004**
(21) Anmeldenummer: 03015393.6
(22) Anmeldetag: 08.07.2003
(51) Int. Cl.: H01J 37/28

(54) **Verfahren und Vorrichtung zum elektronenmikroskopischen Beobachten einer Halbleiteranordnung**

(30) Priorität: 09.07.2002 DE 10230929
(71) Anmelder: LEO Elektronenmikroskopie GmbH, 73447 Oberkochen (DE)
(72) Erfinder: Kienzle, Oliver, Dr., 73430 Aalen (DE); Knippelmeyer, Rainer, Dr., 73431 Aalen (DE); Müller, Ingo, Dr., 73430 Aalen (DE)
(74) Vertreter: DIEHL GLAESER HILTL & PARTNER

(57) **Zusammenfassung**

Es wird ein Verfahren zum elektronenmikroskopischen Beobachten einer Halbleiteranordnung (3) vorgeschlagen, umfassend:
Bereitstellen einer Elektronenmikroskopieoptik (27) zum Abbilden von Sekundärelektronen, welche aus der Halbleiteranordnung (3) innerhalb eines ausgedehnten Objektfeldes (37) austreten, auf einen ortsauflösenden Detektor (35),
Bereitstellen einer Beleuchtungseinrichtung (55, 59) zur Emission eines Primärenergiestrahls (51, 53),
Richten des Primärenergiestrahls (51, 53) auf wenigstens das Objektfeld (37), um dort aus der Halbleiteranordnung (3) Sekundärelektronen auszulösen.

Das Verfahren zeichnet sich dadurch aus, daß die Halbleiteranordnung (3) einen Bereich mit einer von einem ersten Material bereitgestellten obenliegenden Oberfläche und einer von der obenliegenden Oberfläche umgebenen Ausnehmung mit hohem Aspekt-Verhältnis aufweist, welche einen Boden aufweist, der von einem zweiten Material bereitgestellt ist.

## Beschreibung

Die Erfindung betrifft ein Verfahren zum elektronenmikroskopischen Beobachten einer Halbleiteranordnung mit einer Topologie, welche Strukturen mit einem hohem Aspektverhältnis ("High Aspect-Ratio") aufweist.

Ferner betrifft die Erfindung eine Vorrichtung, um eine derartige Halbleiteranordnung zu beobachten.

Strukturen mit hohem Aspektverhältnis treten in der Halbleiterfertigung regelmäßig auf. Dies sind beispielsweise Kontaktlöcher ("contact holes"), Gräben ("trenches"), usw.

Zur Abbildung von Halbleiterstrukturen und insbesondere zur Sichtbarmachung von Defekten in solchen Halbleiterstrukturen während der Fertigung werden herkömmlicherweise elektronenmikroskopische Verfahren eingesetzt.

Ein weit verbreitetes Verfahren ist hierzu die Abbildung von Halbleiterstrukturen mittels eines Rasterelektronenmikroskops ("Scanning Electron Microscope", "SEM"). Es hat sich jedoch herausgestellt, daß die Abbildung von Strukturen mit hohem Aspektverhältnis mit einem Rasterelektronenmikroskop schwierig ist, da Sekundärelektronen, die an Böden von tiefer liegenden Teilen der Strukturen austreten, von den Wänden solcher Strukturen absorbiert werden und hierdurch zu einem großen Teil nicht in das Objektiv des Mikroskops eintreten können. Somit können tieferliegende Strukturen mit einem SEM nicht zufriedenstellend abgebildet werden.

Aus US 6,232,787 B1 ist ein Verfahren bekannt, bei dem mittels eines Rasterelektronenmikroskops obenliegende Oberflächen der zu untersuchenden Halbleiterstruktur gegenüber einem Boden einer von der obenliegenden Oberfläche umgebenen Ausnehmung mit hohem Aspektverhältnis negativ aufgeladen werden. Durch diese Aufladung werden bei der Abbildung der Halbleiterstruktur gezielt Artefakte erzeugt. Diese Artefakte machen es möglich, auf Fertigungsfehler der Struktur mit hohem Aspektverhältnis, beispielsweise einem Loch, zu schließen. Die Artefakte führen nämlich dazu, daß ein mit einem Defekt gefertigtes Loch in der elektronenmikroskopischen Abbildung größer oder kleiner erscheint als ein der Spezifikation entsprechendes Loch. Es wird hierbei allerdings vorausgesetzt, daß ein jedes Loch eine vorbekannte Lochgröße aufweist, welche dann mit der in der elektronenmikroskopischen Abbildung erscheinenden Lochgröße verglichen wird. Eine zufriedenstellende Abbildung des Lochbodens ist allerdings auch mit diesem Verfahren nicht möglich.

Es ist demgemäß eine Aufgabe der vorliegenden Erfindung, ein Verfahren zur elektronenmikroskopischen Beobachtung von Halbleiterstrukturen vorzuschlagen, welches es erlaubt, Strukturen mit hohem Aspektverhältnis mit größerer Flexibilität zu beobachten.

Insbesondere ist es eine Aufgabe der Erfindung, im wesentlichen artefaktfreie Bilder von tieferliegenden Strukturen zu erhalten und auch eine Qualifizierung der gefertigten Strukturen ohne Vorkenntnis von deren Geometrie zu ermöglichen.

Ferner ist es auch eine Aufgabe der Erfindung, ein Elektronenmikroskopiesystem bereitzustellen, mit welchem derartige Halbleiterstrukturen vorteilhaft beobachtbar sind.

Erfindungsgemäß ist vorgesehen, für die Beobachtung von Strukturen mit hohem Aspektverhältnis einen Elektronenmikroskoptyp einzusetzen, welcher in der Fachwelt als "SEEM" (Secondary Electron Emission Microscope) bezeichnet wird.

Bei einem Rasterelektronenmikroskop (SEM) wird eine Aufnahme des zu untersuchenden Objekts dadurch gewonnen, daß ein fein fokussierter Primärelektronenstrahl die Oberfläche des Objekts abtastet und aus dem Objekt austretende Sekundärelektronen ortsunabhängig registriert werden. Die Ortsauflösung des Bildes wird hierbei durch die Kenntnis des Ortes, auf den der Primärelektronenstrahl gerichtet ist, gewonnen. Hiergegen wird bei einem SEEM ein gesamtes beobachtetes, ausgedehntes Objektfeld gleichzeitig mit einem entsprechend ausgedehnten Elektronenstrahl beleuchtet, und die aus diesem Objektfeld austretenden Sekundärelektronen werden derart auf einen ortsauflösenden Detektor abgebildet, daß dort ein im wesentlichen scharfes Abbild des beobachteten Objektfelds entsteht.

Um diese ortsgetreue Abbildung der Sekundärelektronen von dem Objektfeld auf den Detektor zu ermöglichen, ist es notwendig, unmittelbar in der Nähe des Objekts ein starkes elektrisches Feld im wesentlichen normal zur Oberfläche des Objekts anzulegen, welches als Zugfeld wirkt und die Elektronen von der Oberfläche weg beschleunigt. Hierdurch wird vermieden, daß Elektronen, wie mit einer quer zur Oberflächennormalen gerichteten Bewegungskomponente emittierte Sekundärelektronen große Wege quer zur Oberflächennormalen zurücklegen und hierdurch eine übermäßige und nicht mehr zu kompensierende Bildunschärfe erzeugen. Aufgrund dieses starken, elektrischen Zugfeldes, welches bei einem SEEM zwischen Probe und SEEM-Objektiv anzulegen ist, wurde das SEEM bislang lediglich zur Beobachtung von Objekten eingesetzt, welche eine im wesentlichen plane Gestalt aufweisen. Es wurde davon ausgegangen, daß räumlich strukturierte Objekte zu einer lokalen Verzerrung des Zugfeldes führen, welche die gewünschte hohe Auflösung des Elektronenmikroskops zunichte machen. Insbesondere wurde ein SEEM zur Beobachtung von solchen Halbleiterstrukturen nicht für einsetzbar gehalten, welche eine etwas stärker strukturierte Topographie aufweisen, so daß an Kanten der Halbleiterstrukturen aufgrund einer Spitzenwirkung elektrische Feldstärken erzeugt werden, welche auch quer zur Normalen auf die Gesamtoberfläche eines Halbleiterwafers gerichtete Felderkomponenten aufweisen und damit eine ortsgetreue Abbildung der emittierten Elektronen auf den Detektor verhindern. Besonders hohe an derartigen Kanten entstehende elektrische Felder können sogar zu elektrischen Überschlägen innerhalb der Halbleiterstrukturen und gegebenenfalls zu deren Zerstörung führen.

Die Erfinder haben nun herausgefunden, daß Halbleiterstrukturen, welche ein hohes Aspektverhältnis aufweisen, mit einem SEEM überraschend gut abgebildet werden können.

Die Erfindung basiert somit auf der Erkenntnis, daß ein Elektronenmikroskop von der als SEEM bezeichneten Bauart für die Beobachtung von Halbleiterstrukturen mit hohem Aspektverhältnis einsetzbar ist.

Die Erfindung geht somit aus von einem Verfahren zum elektronenmikroskopischen Beobachten eines Objekts mittels eines Elektronenmikroskoptyps, welcher ein als SEEM bezeichnetes Elektronenmikroskop umfaßt. Dieses Verfahren umfaßt somit:
- Bereitstellen einer Elektronenmikroskopieoptik zum Abbilden von Sekundärelektronen, welche aus einem räumlich ausgedehnten Objektfeld des Objekts austreten, auf einen ortsauflösenden Detektor,
- Bereitstellen einer Beleuchtungseinrichtung zur Emission eines Primärenergiestrahls und Richten des Primärenergiestrahls auf wenigstens das Objektfeld, um aus diesem Sekundärelektronen auszulösen.

Die Abbildung des Objektfelds auf den Detektor erfolgt hierbei ortserhaltend, das heißt eine in dem Objekt vorhandene Topologie wird auf den ortsauflösenden Detektor abgebildet, so daß aus dem Bild, das mit dem ortsauflösenden Detektor gewonnen wird, auf die Ortsstruktur des Objekts geschlossen werden kann. Der Primärenergiestrahl soll nicht auf einen Elektronenstrahl beschränkt sein, sondern jegliche Art von Energie umfassen, welche geeignet ist, aus dem zu untersuchenden Objekt Sekundärelektronen auszulösen, nämlich beispielsweise einen Photonenstrahl oder einen Ionenstrahl.

Die Erfindung zeichnet sich hierbei dadurch aus, daß dieses Verfahren angewendet wird auf die Untersuchung einer Halbleiterstruktur mit hohem Aspektverhältnis, wie etwa einer Struktur, die eine von einem ersten Material bereitgestellte obenliegende Oberfläche und eine von der obenliegenden Oberfläche umgebene Ausnehmung mit hohem Aspektverhältnis aufweist, deren Boden von einem zweiten Material bereitgestellt ist.

Hierbei kann das erste Material von dem zweiten Material verschieden sein, es ist jedoch auch möglich, daß das erste und das zweite Material beide das gleiche Material umfassen.

Eine Struktur mit einem hohem Aspektverhältnis ist im Sinne dieser Anmeldung eine solche Struktur, welche für den Fall der Ausnehmung ein Verhältnis von deren Tiefe zu einer Querabmessung derselben von größer als 1,5, vorzugsweise größer als 4,0, weiter bevorzugt größer als 10,0 und noch weiter bevorzugt größer als 15,0 aufweist.

Es hat sich herausgestellt, daß mit diesem Verfahren Strukturen mit hohem Aspektverhältnis überraschend gut beobachtbar sind und insbesondere auch ortsaufgelöste Bilder beispielsweise von Bodenflächen derartiger Ausnehmungen mit hohem Aspektverhältnis gewonnen werden können.

Bevorzugterweise wird der Primärenergiestrahl durch einen Primärelektronenstrahl bereitgestellt, und das Verfahren wird hierbei vorzugsweise auch zur Untersuchung von solchen Strukturen eingesetzt, bei denen das erste Material elektrisch im wesentlichen nicht leitend ist. Hierbei ist bevorzugt, eine kinetische Energie der Elektronen des Primärelektronenstrahls derart einzustellen, daß sich die obenliegende Oberfläche relativ zu dem Boden positiv auflädt. Bei einer solchen Ladungskonfiguration zwischen Boden und obenliegender Oberfläche entsteht innerhalb der Ausnehmung ein elektrisches Feld, welches eine Fortsetzung eines Zugfeldes bildet, welches zwischen einem Objektiv der Elektronenmikroskopieoptik und der obenliegenden Oberfläche der zu untersuchenden Struktur angelegt ist. Wäre eine solche Ladungskonfiguration nicht vorhanden, würde das Zugfeld in der Ausnehmung teilweise abgeschirmt sein und nicht ausreichend bis zu deren Boden in diese eindringen können. Somit wird durch diese Ladungskonfiguration auch in der Nähe des Bodens der Ausnehmung ein elektrisches Feld bereitgestellt, welches als Zugfeld wirkt und die aus dem Boden austretenden Sekundärelektronen hin zu der Elektronenmikroskopieoptik beschleunigt, so daß auch räumliche Strukturen am Boden der Ausnehmung ortsaufgelöst auf den Detektor abgebildet werden können.

Die kinetische Energie der Elektronen des Primärelektronenstrahls wird zur Erzielung einer solchen Ladungskonfiguration vorzugsweise auf der Grundlage der folgenden Überlegung eingestellt:

Ein elektrisch im wesentlichen nicht-leitendes Material weist eine Sekundärelektronenausbeutecharakteristik auf, welche in Abhängigkeit der Energie der Primärelektronen einen ersten und einen zweiten Neutralpunkt und ein zwischen den beiden Neutralpunkten angeordnetes Maximum aufweist. Die Sekundärelektronenausbeute σ ist hierbei definiert als das Verhältnis zwischen den auf die Probe eingestrahlten Primärelektronen und den von der Probe austretenden Sekundärelektronen.

Unter der Energie der Primärelektronen wird genauer die kinetische Landeenergie, das heißt die Energie, mit der die Primärelektronen auf die Probenoberfläche auftreffen, verstanden.

Für niedrige Energien der Primärelektronen unterhalb des ersten Neutralpunkts, werden weniger Sekundärelektronen aus dem Objekt ausgelöst als Primärelektronen auf dieses auftreffen, weshalb sich das Objekt negativ auflädt. Am ersten Neutralpunkt werden im wesentlichen genauso viele Sekundärelektronen ausgelöst wie Primärelektronen auf dieses auftreffen, und eine Aufladung des Objekts erfolgt im wesentlichen nicht. Bei Energien zwischen dem ersten und dem zweiten Neutralpunkt werden von dem Objekt mehr Sekundärelektronen ausgelöst als Primärelektronen auf dieses auftreffen, weshalb sich das Objekt positiv auflädt. Oberhalb des zweiten Neutralpunkts ist die Energie der Primärelektronen so hoch, daß diese tief in das Objekt eindringen und vergleichsweise wenig Sekundärelektronen aus dessen Oberflächenbereichen auslösen, so daß sich das Objekt negativ auflädt.

Zur Erzielung der positiven Aufladung der obenliegenden Oberfläche relativ zum Boden der Ausnehmung wird somit die kinetische Energie der Elektronen des Primärelektronenstrahls vorzugsweise auf einen Energiewert eingestellt, der größer ist als ein entsprechender Energiewert des ersten Neutralpunkts der Sekundärelektronenausbeutecharakteristik des ersten Materials, das heißt des Materials, welches die obenliegende Oberfläche bereitstellt.

Ein elektrisch im wesentlichen nicht-leitendes Material ist im Rahmen dieser Anmeldung ein Halbleiter mit auf seine jeweilige Anwendung bezogen mittlerer Dotierung, vorzugsweise ein Halbleiter mit auf seine jeweilige Anwendung bezogen, schwacher Dotierung, weiter bevorzugt ein im wesentlichen undotierter Halbleiter und insbesondere ein Material, welches in der Halbleiterfertigung als Isolator eingesetzt wird, wie beispielsweise Siliziumoxid, Siliziumdioxid, Siliziumnitrid oder ähnliche. Des weiteren sind Nichtleiter hier Materialien, die während des Herstellungsprozesses des Halbleiters unbeabsichtigt auf den Boden der Ausnehmung gelangt sind und dort eine elektrische Kontaktierung behindern würden, wie etwa Reste eines Photolacks oder dergleichen.

Ein elektrisch im wesentlichen leitendes Material ist im Sinne dieser Anmeldung beispielsweise ein Material zur Fertigung einer Leiterbahn aus beispielsweise einem Metall, ein stark dotierter Halbleiter oder auch ein bezogen auf seine Anwendung mittel dotierter Halbleiter.

Ist auch das zweite Material, das heißt das Material des Bodens der Ausnehmung ein im wesentlichen nicht leitendes Material, so weist dies eine ähnliche Sekundärelektronenausbeutecharakteristik auf, wie dies vorangehend für das erste Material geschildert wurde. Allerdings können die beiden Materialien voneinander verschiedenen sein, und die Sekundärelektronenausbeutecharakteristiken der beiden Materialien unterscheiden sich dann beispielsweise hinsichtlich der Energien, an denen die ersten und zweiten Neutralpunkte und die jeweiligen Maxima auftreten.

Hierbei wird dann vorteilhafterweise die kinetische Energie der Primärelektronen auf einen Energiewert eingestellt, an dem die Sekundärelektronenausbeutecharakteristik des ersten Materials größer ist als die des zweiten Materials.

Tritt das Maximum der Sekundärelektronenausbeutecharakteristik des ersten Materials beispielsweise bei einer höheren Energie auf als das entsprechende Maximum für das zweite Material, so wird die kinetische Energie der Primärelektronen vorzugsweise auf einen Energiewert eingestellt, der größer ist als eine Energie, an der sich die Sekundärelektronenausbeutecharakteristika der beiden Materialien schneiden. In diesem Energiebereich ist die Sekundärelektronenausbeute für das Material der obenliegenden Oberfläche größer als für das Material des Bodens der Ausnehmung, so daß sich eine positive Aufladung der obenliegenden Oberfläche relativ zum Boden der Ausnehmung leicht einstellt.

Alternativ oder ergänzend zu der Bereitstellung des Primärenergiestrahls durch einen Primärelektronenstrahl kann der Primärenergiestrahl auch einen Photonenstrahl oder/und Ionenstrahl umfassen. Auch Photonen oder Ionen sind dazu geeignet, aus dem zu untersuchenden Objekt Sekundärelektronen auszulösen, welche dann durch die Elektronenmikroskopieoptik auf den ortsauflösenden Detektor abbildbar sind.

Da der Photonenstrahl selbst keine Ladung auf das Objekt aufbringt, führen die von den Photonen aus dem Objekt ausgelösten Sekundärelektronen zu einer positiven Aufladung des Objekts, weshalb durch den Einsatz eines Photonenstrahls, vergleichsweise einfach eine positive Aufladung von Bereichen des Objekts erzielt werden kann.

Umgekehrt tragen die Ionen eines Ionenstrahls zu einer aufgrund ihrer eigenen in der Regel positiven Ladung zur Aufladung der Probe bei, was ebenfalls zur Erzeugung einer gewünschten Ladungskonfiguration an der Halbleiterstruktur ausgenutzt werden kann.

Vorzugsweise ist hierbei vorgesehen, daß der Photonenstrahl quer zu einer Normalen auf die obenliegende Oberfläche aufgestrahlt wird und mit dieser insbesondere einen Winkel zwischen 10 ° und 80 ° einschließt. Hierdurch ist es nämlich möglich, daß der schräg auf die obenliegende Oberfläche auftreffende Photonenstrahl nicht auf den Boden der Ausnehmung auftrifft, so daß die gewünschte positive Aufladung der obenliegenden Oberfläche relativ zu dem Boden der Ausnehmung einfach erzielt werden kann.

Andererseits ist es ebenfalls möglich, den Photonenstrahl im wesentlichen normal auf die obenliegende Oberfläche zu richten, so daß er auch den Boden der Ausnehmung erreicht. Eine positive Aufladung der obenliegenden Oberfläche relativ zu dem Boden stellt sich im wesentlichen dann ein, wenn das erste Material und das zweite Material voneinander verschieden sind.

Vorzugsweise ist ferner vorgesehen, daß die Elektronenmikroskopieoptik dazu ausgebildet ist, das Objektfeld, das auf den Detektor abgebildet wird, relativ zu dem Detektor in einer Ebene der obenliegenden Oberfläche zu verlagern. Hierdurch ist es möglich, verschiedene Bereiche des zu beobachtenden Objekts auf den Detektor abzubilden, ohne das Objekt mechanisch relativ zu dem Detektor verlagern zu müssen.

Eine solche Elektronenmikroskopieoptik ist in der gleichfalls anhängigen Patentanmeldung DE 101 31 931.2 der Anmelderin beschrieben. Die Offenbarung dieser Anmeldung wird durch Inbezugnahme vollumfänglich hier aufgenommen.

Ferner ist es vorteilhaft, daß die Elektronenmikroskopieoptik einen abbildungserhaltenden Energiefilter aufweist, so daß die Energie der Sekundärelektronen, welche auf den Detektor abgebildet werden, auswählbar ist. Ein solcher Energiefilter ist beispielsweise aus EP 0 218 920 A2 bekannt. Insbesondere ist es dann möglich, den abbildungserhaltenden Energiefilter derart einzustellen, daß von der positiv aufgeladenen obenliegenden Oberfläche ausgelöste Sekundärelektronen im wesentlichen nicht auf den Detektor abgebildet werden. Entsprechend werden im wesentlichen nur Sekundärelektronen ortsaufgelöst auf den Detektor abgebildet, welche von dem Boden der Ausnehmung austreten, so daß deren Strukturen mit vergleichsweise guter Qualität in dem von dem Detektor ausgelesenen Bild erkennbar sind.

Unter einem weiteren Aspekt sieht die Erfindung eine Elektronenmikroskopiesystem vor, welches eine Steuerung mit einem Speicher umfaßt, um vorbestimmte Einstellungen von Werten einer unteren oder/und oberen Energiegrenze eines Energiefensters oder/und einer kinetischen Energie von Elektronen eines Primärelektronenstrahls zu speichern.

Ausführungsformen der Erfindung werden nachfolgend anhand von Zeichnungen näher erläutert. Hierbei zeigt
- Figur 1: eine schematische Darstellung eines Elektronenmikroskops zur Ausführung einer Ausführungsform des erfindungsgemäßen Verfahrens,
- Figur 2: eine schematische Schnittdarstellung einer mit dem Elektronenmikroskop der Figur 1 beobachteten Halbleiterstruktur mit hohem Aspektverhältnis,
- Figur 3: eine Graphik einer Sekundärelektronenausbeutecharakteristik für ein Material der in Figur 2 gezeigten Struktur,
- Figur 4: Energiespektren von Sekundärelektronen, die aus der in Figur 2 gezeigten Struktur austreten,
- Figur 5: eine schematische Darstellung eines in dem Elektronenmikroskop der Figur 1 eingesetzten, abbildungserhaltenden Energiefilters,
- Figur 6: eine mit dem in Figur 1 gezeigten Elektronenmikroskop aufgenommene Abbildung einer Halbleiteranordnung mit Strukturen mit hohem Aspektverhältnis bei einer ersten Einstellung eines ähnlich des in Figur 5 gezeigten Energiefilters,
- Figur 7: eine mit dem in Figur 1 gezeigten Elektronenmikroskop aufgenommene Abbildung einer Halbleiteranordnung mit Strukturen mit hohem Aspektverhältnis bei einer zweiten Einstellung des in Figur 5 gezeigten Energiefilters,
- Figur 8: Graphen von Sekundärelektronenausbeutecharakteristika für Materialien einer Halbleiterstruktur, welche ähnlich der in Figur 2 gezeigten Struktur ist,
- Figur 9: eine schematische Darstellung eines weiteren Elektronenmikroskops, welches zur Ausführung einer Ausführungsform des erfindungsgemäßen Verfahrens geeignet ist,
- Figur 10: eine schematische Explosionsdarstellung einer Objektivanordnung des in Figur 9 gezeigten Elektronenmikroskops,
- Figur 11: mehrere schematische Darstellungen von Feldkonfigurationen zur Erläuterung der Funktion des in Figur 10 gezeigten Objektivs,
- Figur 12: eine schematische Darstellung eines weiteren Elektronenmikroskops, welches zur Ausführung einer Ausführungsform des erfindungsgemäßen Verfahrens geeignet ist, und
- Figur 13: Strukturen mit hohem Aspektverhältnis und Defekten zur Erläuterung weiterer Ausführungsformen des erfindungsgemäßen Verfahrens.

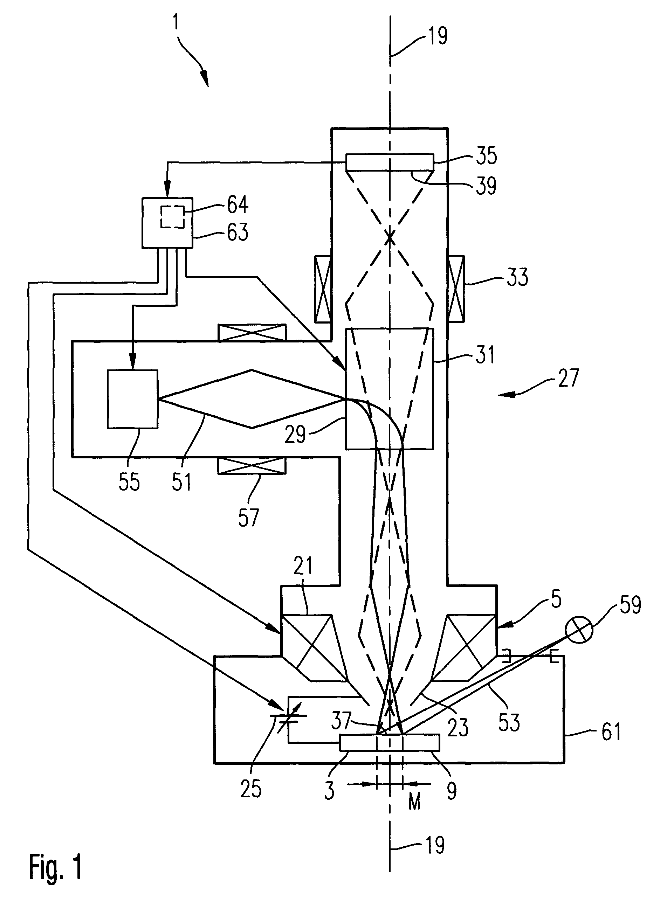

In Figur 1 ist ein Elektronenmikroskop 1 schematisch dargestellt, welches zur Ausführung des erfindungsgemäßen Verfahrens geeignet ist. Das Elektronenmikroskop 1 dient zur Untersuchung einer Halbleiterstruktur 3, welche als zu untersuchendes Objekt vor einer Objektivanordnung 5 des Elektronenmikroskops 1 angeordnet ist.

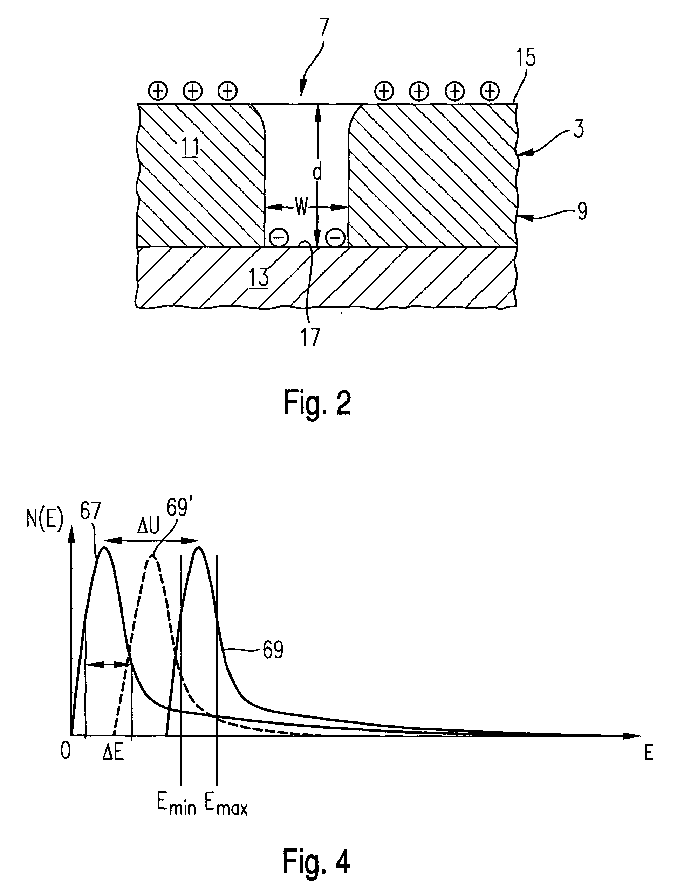

Die Halbleiteranordnung 3 ist beispielsweise Teil eines Halbleiterwafers oder ähnliches und weist eine Topologie mit Strukturen mit hohem Aspektverhältnis auf, wie dies in Figur 2 anhand einer Ausnehmung 7 schematisch dargestellt ist. Die in Figur 2 gezeigte Struktur 3 ist Teil eines Halbleiterwafers 9 und umfaßt eine Schicht 11 aus SiO₂ einer Dicke d von beispielsweise 2,5 µm, welche auf einer Schicht 13 aus einem Metall, wie beispielsweise Kupfer aufgebracht ist. Die SiO₂-Schicht 11 weist eine obenliegende Oberfläche 15 auf, welche der Objektivanordnung 5 des Mikroskops 1 zugewandt ist. In der SiO₂-Schicht 11 ist die Ausnehmung 7 eingebracht und reicht von der Oberfläche 15 durch die SiO₂-Schicht 11 als Durchgangsloch hindurch bis zu der Metallschicht 13, welche einen Boden 17 der Ausnehmung 7 bildet. Die Ausnehmung 7 weist eine Ausdehnung w quer zur obenliegenden Oberfläche 15 von 250 nm auf.

Die Objektivanordnung 5 des Elektronenmikroskops 1 ist im wesentlichen symmetrisch bezüglich einer optischen Achse 19 der Objektivanordnung 5 angeordnet und umfaßt eine Magnetwicklung 21 zur Erzeugung eines fokussierenden Magnetfelds und eine Blendenelektrode 23, welche bezüglich des Halbleiterwafers 9 mittels einer steuerbaren Spannungsquelle 25 auf positivem Potential gehalten wird. Allerdings kann ein elektrisches Extraktionsfeld auch zwischen der Blendenelektrode 23 und einem, den Wafer haltenden, verschiebbaren Positionierungstisch (nicht dargestellt) angelegt werden.

Das Potential zwischen der Blendenelektrode 23 und dem mit dem Elektronenmikroskop 1 zu untersuchenden Objekt, nämlich der Halbleiteranordnung 3, dient dazu, über der Oberfläche 15 des Wafers 9 ein elektrostatisches Zugfeld bereitzustellen, welches dazu dient, Sekundärelektronen, welche aus der Halbleiterstruktur 3 austreten, hin zu der Blendenelektrode zu beschleunigen, so daß die Sekundärelektronen diese Blendenelektrode 23 durchsetzen und in die Objektivanordnung 5 eintreten.

Die Objektivanordnung 5 ist Teil einer Elektronenmikroskopieoptik 27, welche weiter einen abbildungserhaltenden Energiefilter 31, eine Nachvergrößerungsoptik 33 und einen ortsauflösenden Elektronendetektor 35, wie beispielsweise einen CCD-Chip, umfaßt. Die Elektronenmikroskopieoptik 27 ist so ausgelegt, daß ein flächig ausgedehnter Bereich 37 mit einem Durchmesser M von 9 µm des zu untersuchenden Objekts auf eine sensitive Oberfläche 39 des ortsauflösenden Detektors 35 elektronenoptisch im wesentlichen scharf abgebildet ist. Diese Abbildung erfolgt ortserhaltend, das heißt einem jeden Punkt innerhalb des Bereichs 37 ist über die elektronenoptische Abbildung ein korrespondierender Punkt auf der Detektoroberfläche 39 zugeordnet, auf den die Elektronen abgebildet werden, welche an dem entsprechenden Punkt in dem Bereich 37 aus der Halbleiteranordnung 3 austreten.

Die aus der Halbleiteranordnung 3 austretenden Sekundärelektronen werden somit zunächst in dem zwischen dem Wafer 9 und der Blendenelektrode 23 angelegten Zugfeld in Richtung der optischen Achse 19 beschleunigt, treten dann in die Objektivanordnung 5 ein, werden dort von dem durch die Magnetwicklung 21 erzeugten fokussierenden Feld fokussiert, wobei sie sich in Richtung der optischen Achse 19 weiterbewegen. Die Sekundärelektronen durchlaufen dann den abbildungserhaltenden Energiefilter 31, welcher, unter Erhaltung der durch die Elektronenmikroskopieoptik abgebildeten Ortsinformation von den Elektronen aus dem in den Energiefilter 31 eintretenden Strahl einen solchen Teilstrahl durchtreten läßt, welcher im wesentlichen nur Elektronen mit einer kinetischen Energie innerhalb eines begrenzten Energiebereichs bzw. Energiefensters aufweist.

Nach ihrem Austritt aus dem Energiefilter 31 durchlaufen die von dem Energiefilter 31 selektierten Elektronen die Nachvergrößerungsoptik 33, welche zu einer weiteren Erhöhung der von dem Elektronenmikroskop 1 erzielbaren Vergrößerung dient, bevor die Elektronen dann auf die sensitive Fläche 39 des ortsauflösenden Detektors 35 treffen.

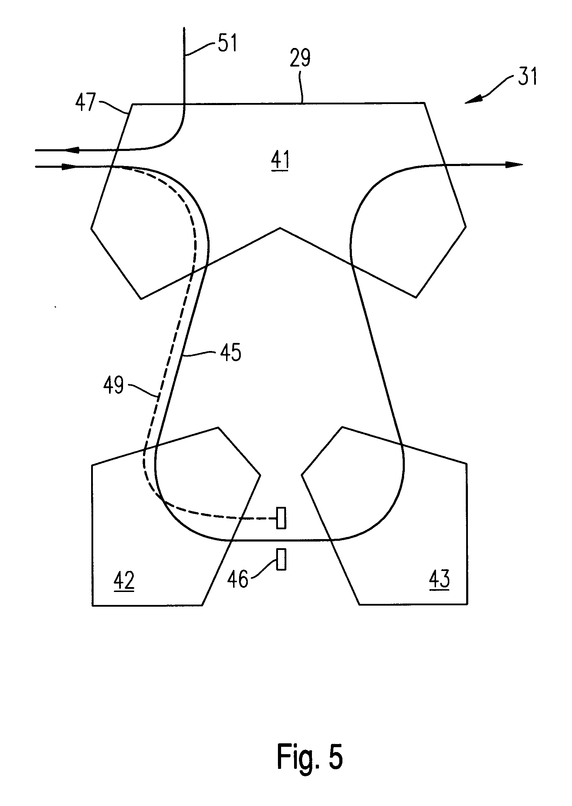

Der abbildungserhaltende Energiefilter 31 ist in Figur 5 etwas detaillierter schematisch dargestellt. Der Energiefilter 31 umfaßt drei Sektormagnete 41, 42 und 43 und eine Aperturblende 46. Der Strahlverlauf durch den Energiefilter 31 wird zunächst für einen Elektronenstrahl 45 erläutert, dessen Elektronen eine erste kinetische Energie aufweisen. Der Elektronenstrahl 45 tritt an einer Eingangsseite 47 in den Sektormagneten 41 und wird durch diesen nach rechts um einen Winkel von etwas größer als 90 ° abgelenkt, wonach er aus dem Sektormagneten 41 wieder austritt. Sodann tritt der Elektronenstrahl 45 in den Sektormagneten 42 ein, wird von diesen nach links um einen Winkel von wiederum größer als 90 ° abgelenkt, bevor er aus dem Sektormagnet 42 austritt, um die Aperturblende 46 zu durchsetzen. Der Aufbau des Energiefilters 31 ist bezüglich der Ebene der Aperturblende 46 symmetrisch, so daß der Elektronenstrahl nach dem Durchsetzen der Aperturblende 46 durch den Sektormagneten 43 nach links abgelenkt wird und hiernach erneut in den Sektormagneten 41 eintritt, um durch diesen nach rechts derart abgelenkt zu werden, daß er den Sektormagneten 41 in einer im wesentlichen gleichen Richtung verläßt, wie er vorher in diesen eingetreten ist. Die Sektormagneten 41 und 42 wirken zusammen als Linse derart, daß in der Aperturblende 46 ein Strahl-Cross-Over entsteht, das heißt daß der Strahl 45 in der Ebene der Aperturblende 46 im wesentlichen scharf fokussiert ist.

Elektronen, welche eine niedrigere Energie aufweisen, als die Elektronen des Strahls 45, verlaufen auf der in Figur 5 mit 49 bezeichneten Bahn: sie werden in dem Sektormagneten 41 um einen größeren Winkel abgelenkt als die Elektronen in dem Strahl 45, worauf sie in dem Sektormagneten 42 ebenfalls um einen größeren Winkel abgelenkt werden als die Elektronen des Strahls 45 und aus diesem Grund in etwa parallel versetzt zu dem Strahl 45 aus dem Sektormagneten 42 austreten und die Aperturblende 46 nicht durchsetzen können.

Um aus dem flächig ausgedehnten Bereich 37 Sekundärelektronen auszulösen, ist eine Beleuchtungseinrichtung vorgesehen, die dem Bereich 37 Energie über einen Primärenergiestrahl zuführt. Dieser Primärenergiestrahl umfaßt bei dem Elektronenmikroskop 1 einen Primärelektronenstrahl 51 sowie einen Photonenstrahl 53.

Der Primärelektronenstrahl 51 wird durch eine Elektronenquelle 55 erzeugt und zunächst in einer Richtung quer zur optischen Achse 19 emittiert. Die kinetische Energie der Primärelektronen ist dabei mittels einer in die Elektronenquelle integrierten, ansteuerbaren Beschleungigungselektrode einstellbar.

Der Primärelektronenstrahl 51 durchläuft sodann eine Fokussieroptik 57 und tritt in einen Teil des Energiefilters 31 ein, welcher für den Primärelektronenstrahl 51 die Funktion eines Strahlablenkers 29 aufweist. Durch den Strahlablenker 29 wird der Primärelektronenstrahl 51 derart umgelenkt, daß er entlang der optischen Achse 19 hin zu dem Halbleiterwafer 9 verläuft und durch die Objektivanordnung 5 derart fokussiert wird, daß er den flächig ausgedehnten Bereich 37 auf dem Wafer 9 mit im wesentlichen gleichförmig verteilter Intensität beleuchtet. Aus Figur 5 ist ersichtlich, daß der Sektormagnet 41 des Energiefilters 31 den Strahlablenker 29 bildet.

Der Photonenstrahl 53 wird von einer geeigneten Photonenquelle 59 erzeugt, welche beispielsweise durch einen Laser bereitgestellt sein kann. Die Photonenquelle 59 kann außerhalb eines Vakuummantels 61 angeordnet sein, in dem der Halbleiterwafer 9 vor der Elektronenmikroskopieoptik 27 angeordnet ist. Der Strahl 53 durchsetzt den Vakuummantel 61 durch ein geeignetes Fenster.

Eine Steuerung 63 ist vorgesehen, um eine Energie der von der Elektronenquelle 55 emittierten Primärelektronen 51 einzustellen, um die von der Spannungsquelle 25 bereitgestellte Spannung zur Erzeugung des Zugfelds einzustellen, um den Strahlablenker 29 zur Ablenkung des Primärelektronenstrahls und zur Ablenkung des Sekundärelektronenstrahls einzustellen, um an dem Energiefilter 31 einen Bereich der kinetischen Energie der Sekundärelektronen, welche Sekundärelektronen aufweisen müssen, um den Energiefilter 31 zu durchsetzen, einzustellen und um die von dem Detektor 35 ausgelesenen Bilder in Empfang zu nehmen.

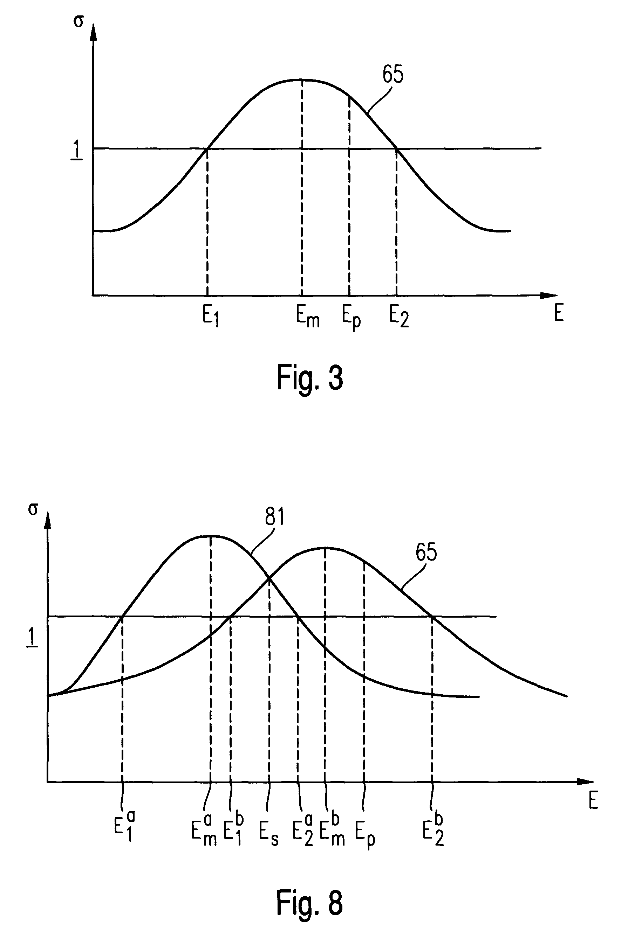

In Figur 3 ist eine Sekundärelektronenausbeute σ für die Materialien der in Figur 2 gezeigten Halbleiteranordnung 3 in Abhängigkeit von der kinetischen Energie der auf die Materialien auftreffenden Primärelektronen schematisch dargestellt. Für das SiO₂-Material 11 weist die Sekundärelektronenausbeutecharakteristik einen Verlauf auf, wie er durch eine Kurve 65 dargestellt ist.

Für Primärelektronenenergien unterhalb eines ersten Neutralpunkts E₁ werden weniger Sekundärelektronen aus dem Material ausgelöst als Primärelektronen auf dieses auftreffen, weshalb die Sekundärelektronenausbeute kleiner als 1 ist und das Material sich entsprechend negativ auflädt. Oberhalb eines zweiten Neutralpunkts E₂, dessen Energie größer ist als die des ersten Neutralpunkts E₁, werden ebenfalls weniger Sekundärelektronen aus dem Material ausgelöst als Primärelektronen auf dieses auftreffen. Entsprechend wird auch für solche Energien das Material negativ aufgeladen. Zwischen den beiden Neutralpunkten E₁ und E₂ weist die Sekundärelektronenausbeutecharakteristik 65 ein Maximum bei einer Energie Eₘ auf, und für diese Energien werden mehr Sekundärelektronen aus dem Material ausgelöst als Primärelektronen auf dieses auftreffen, weshalb sich das Material sich entsprechend positiv auflädt.

Die Steuerung 63 stellt die Energie der Primärelektronen des Primärelektronenstrahls 51 derart ein, daß die Primärelektronen auf die obenliegende Oberfläche 15 der SiO₂-Schicht 11 mit einer Energie Eₚ von etwa 2 keV auftrifft, welche zwischen den Energien Eₘ und E₂ liegt.

Dies führt zu einer positiven Aufladung der Oberfläche der SiO₂-Schicht 11, wie dies in Figur 2 auch schematisch angedeutet ist.

Die auf dem Boden 17 der Metallschicht 13 auftreffenden Primärelektronen erzeugen zwar eine Anzahl von Sekundärelektronen, welche nicht unbedingt der Zahl der auftreffenden Primärelektronen entsprechen muß. Allerdings ist die Schicht 13 leitend, so daß nennenswerte Aufladungen an dem Boden 17 nicht erzielt werden können. Allerdings ist der Boden 17 relativ zu der obenliegenden Oberfläche 15 negativ aufgeladen, da letztere positiv aufgeladen ist. Diese relative negative Aufladung ist in Figur 2 ebenfalls schematisch dargestellt.

Die negative Aufladung des Bodens 17 relativ zu der obenliegenden Oberfläche 15 führt dazu, daß aus dem Boden 17 austretende Sekundärelektronen bereits innerhalb der Ausnehmung 7 in Richtung zu der Öffnung der Ausnehmung 7 in der obenliegenden Oberfläche 15 beschleunigt werden und diese Öffnung bereits mit einer kinetischen Energie durchsetzen, welche größer ist als eine kinetische Energie, mit der Sekundärelektronen aus der obenliegenden Oberfläche 15 austreten. Dies ist in Figur 4 schematisch erläutert. Darin zeigt eine Kurve 67 ein Energiespektrum der aus der obenliegenden Oberfläche 15 austretenden Sekundärelektronen, das heißt eine Anzahl N(E) dieser Sekundärelektronen in Abhängigkeit von deren kinetischen Austrittsenergie E. Die Kurve 67 weist ein ausgeprägtes Maximum mit einer Halbwertsbreite ΔE auf.

Ein Energiespektrum von Primärelektronen, welche am Boden 17 der Ausnehmung 7 austreten, würde einen sehr ähnlichen Verlauf aufweisen, wie er durch die Kurve 67 in Figur 4 dargestellt ist, wobei allerdings aufgrund der verschiedenen Materialien der Schicht 13 und der Schicht 11 Unterschiede im Verlauf des Spektrums auftreten können. Allerdings werden die am Boden 17 der Ausnehmung 7 austretenden Elektronen durch ein elektrisches Feld innerhalb der Ausnehmung beschleunigt, welches durch die relative negative Aufladung des Boden 17 bezüglich der obenliegenden Oberfläche 15 in der Ausnehmung 7 erzeugt wird. Entsprechend werden die am Boden 17 austretenden Elektronen innerhalb der Ausnehmung 7 beschleunigt und verlassen die Ausnehmung 7 mit einer entsprechend höheren kinetischen Energie. Das Energiespektrum der am Boden 17 austretenden Elektronen am Ort der Ausnehmung in Höhe der obenliegenden Oberfläche 15 ist in Figur 4 durch eine Kurve 69 dargestellt.

Diese weist einen ähnlichen Verlauf auf wie die Kurve 67, ist allerdings um einen Energiebetrag ΔU zu höheren Energien hin relativ zu der Kurve 67 verschoben.

Die Steuerung 63 kann den Energiefilter 31 derart einstellen, daß er im wesentlichen die Elektronen passieren läßt, welche von der obenliegenden Oberfläche 15 austreten und durch die Kurve 67 in Figur 4 repräsentiert sind, oder daß er im wesentlichen die Sekundärelektronen passieren läßt, welche vom Boden 17 der Ausnehmung 7 austreten und welche in Figur 4 durch die Kurve 69 repräsentiert sind.

Dazu kann der Energiefilter in einer ersten Einstellung beispielsweise so eingestellt werden, daß Sekundärelektronen mit einer kinetischen Energie größer als eine einstellbare, erste Schwellenenergie ausgeblendet werden. Wird die erste Schwellenenergie als zwischen den Maxima der beiden Kurven 67, 69 liegend eingestellt, erreichen somit bevorzugt die der Kurve 67 entsprechenden, aus den obenliegenden Probebereichen 15 ausgetretenen Sekundärelektronen den Detektor 35.

Durch eine mögliche zweite Einstellung des Energiefilters, bei der Sekundärelektronen mit Energien kleiner als die erste Schwellenenergie ausgeblendet werden, erreichen bevorzugt aus den Böden 17 ausgetretene Sekundärelektronen den Detektor 35.

Alternativ kann auch eine obere und eine untere Schwellenenergie für den Energiefilter vorgesehen sein, so daß nur Sekundärelektronen innerhalb eines derart begrenzten Energiebereiches den Energiefilter passieren können.

Die Breite des Energiebereichs kann eingestellt werden, indem eine Breite der Aperturblende 46 (Figur 5) des Energiefilters 31 durch mechanisches Verschieben von zwei Hälften der Blende 46 quer zur Richtung des Strahls 45 verändert wird. Das mechanische Verschieben kann entweder von Hand oder motorisch, gesteuert durch die Steuerung 63 erfolgen.

Die Lage des Energiebereichs mit einer durch die Breite der Aperturblende 46 definierten Energiebreite entlang der Energieskala kann entweder durch Ändern der durch die Sektormagnete 41, 42, 43 bereitgestellten Magnetfelder, gesteuert durch die Steuerung 63 erfolgen. Bevorzugt erfolgt dies jedoch durch Ändern der durch die Spannungsquelle 25 zwischen der Blendenelektrode 37 und dem Wafer 3 bereitgestellten elektrischen Spannung. Es wird hierdurch die Stärke des Extraktionsfeldes geändert, und damit auch die kinetische Energie der Sekundärelektronen nach Durchsetzen der Blendenelektrode 23. Die Sekundärelektronen treten dann mit entsprechend höherer bzw. niedrigerer Energie in den Energiefilter 31 ein.

In dem Speicher 64 der Steuerung 63 sind vorzugsweise mehrere Einstellungen der Primärelektronenenergie sowie zugehöriger Einstellungen des Energiefensters, d.h. Einstellungen der Spannungsquelle 25 gespeichert, um das Elektronenmikroskop schnell von einer Einstellung zur anderen umstellen zu können.

Mit einer Änderung des Extraktionsfeldes ändern sich auch die Trajektorien der den Energiefilter passierenden Sekundärelektronen zwischen der Oberfläche des Objekts 3 und der Blendenelektrode 23 sowie weiter die Trajektorien der Sekundärelektronen nach Durchsetzen der Blendenelektrode 23 innerhalb der Magnetlinse 21. Oder anders ausgedrückt, durch Verschieben des Energiefensters werden Sekundärelektronen mit verschiedenen Startenergien an der Probe zur Abbildung ausgewählt. Auf diese Sekundärelektronen mit verschiedenen Startenergien wirkt das Objektiv unterschiedlich fokussierend.

Obwohl diese Änderungen der Trajektorien vergleichsweise klein sind, so ändern sie dennoch eine Fokussierung der Elektronenmikroskopieoptik 27 und damit die Abbildungsqualität, mit der das Objekt auf den Detektor 35 abgebildet wird. Diese durch Änderung des Extraktionsfeldes zur Verschiebung des Energiefensters des Energiefilters 31 hervorgerufene Änderung der Fokussierung wird kompensiert, indem die Steuerung 63 die Erregung der Magnetwicklung 21 der Objektivanordnung 5 entsprechend ändert.

In dem Speicher 64 der Steuerung 63 werden somit ferner zu den verschiedenen Einstellungen des Energiefensters auch Erregungen der Magnetwicklung der Objektivanordnung 5 abgespeichert, um schnell zwischen verschiedenen Einstellungen des Elektronenmikroskops 1 umschalten zu können.

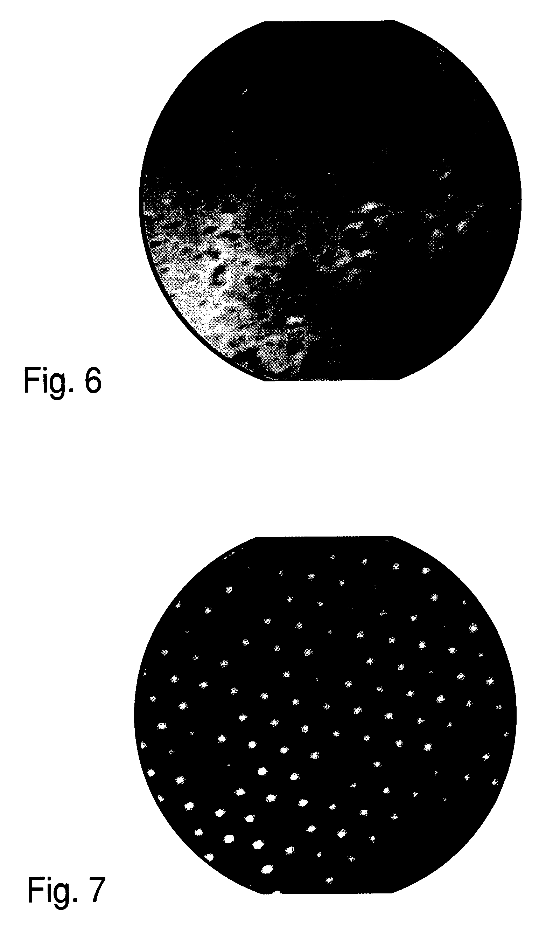

Die Figuren 6 und 7 zeigen mit dem Elektronenmikroskop 1 gewonnene elektronenmikroskopische Aufnahmen des Wafers 9, in dem eine Vielzahl von Ausnehmungen 7 in einer hexagonalen Anordnung eingebracht sind.

Figur 6 zeigt eine Aufnahme, wie sie mit dem Detektor 35 gewonnen wurde, wenn die Steuerung 63 den Energiefilter 31 auf die erste oben genannte Einstellung eingestellt hat, bei der im wesentlichen Sekundärelektronen auf den Detektor 35 treffen, welche von der obenliegenden Oberfläche 15 emittiert wurden. Dies sind im wesentlichen Sekundärelektronen, die in der Ebene 15 der obenliegenden Oberfläche eine kinetische Energie von etwa 2,5 eV aufweisen. Entsprechend wurde für diese Aufnahme der Wert Eₘᵢₙ des Energiefensters (vergleiche Figur 4) auf 1 eV eingestellt und der Wert Eₘₐₓ des Energiefensters wurde auf 4 eV eingestellt. Die Ausnehmungen 7 sind als dunkle Stellen mit allerdings schwachem Kontrast in der Abbildung sichtbar.

Figur 7 ist eine Aufnahme, wie sie von dem Detektor 35 gewonnen wurde, als der Energiefilter 31 auf die oben genannte zweite Einstellung eingestellt war. Hier gelangen im wesentlichen die Elektronen auf den Detektor 35, welche von dem Boden 17 emittiert wurden. Dies sind im wesentlichen Sekundärelektronen, die in der Ebene der obenliegenden Oberfläche aufgrund der Wirkung des elektrischen Feldes innerhalb der Ausnehmung eine höhere kinetische Energie von 12,5 eV aufweisen. Entsprechend wurden für diese Aufnahme die Werte Eₘᵢₙ und Eₘₐₓ auf 11,5 eV bzw. 13,5 eV eingestellt. Entsprechend sind die Ausnehmungen 7 in der Abbildung als helle Bereiche mit gutem Kontrast gegenüber der umgebenden obenliegenden Oberfläche 15 erkennbar.

Die Steuerung 63 des in Figur 1 gezeigten Elektronenmikroskops 1 weist einen Speicher 64 auf, um verschiedene Parameter für den Betrieb des Elektronenmikroskops 1 derart abzuspeichern, daß zwischen verschiedenen Einstellungen schnell umschaltbar ist, wie beispielsweise einer Einstellung zur Sichtbarmachung von insbesondere der obenliegenden Oberfläche 15 gemäß Figur 6 oder einer Einstellung zur Sichtbarmachung der Böden 17 der Ausnehmungen 7 gemäß Figur 7. Für eine jede Einstellung werden insbesondere die untere Energie und die obere Energie des Energiefensters des Energiefilters 31 und die Energie des Primärelektronenstrahls 51 gespeichert. Ferner werden weitere zugehörige Parameter gespeichert, wie beispielsweise Erregungsströme für die Fokussieroptik 57, die Magnetwicklung 21 der Objektivanordnung 5, der Nachvergrößerungsoptik 33 oder einer Zusatzwicklung des Strahlteilers 29.

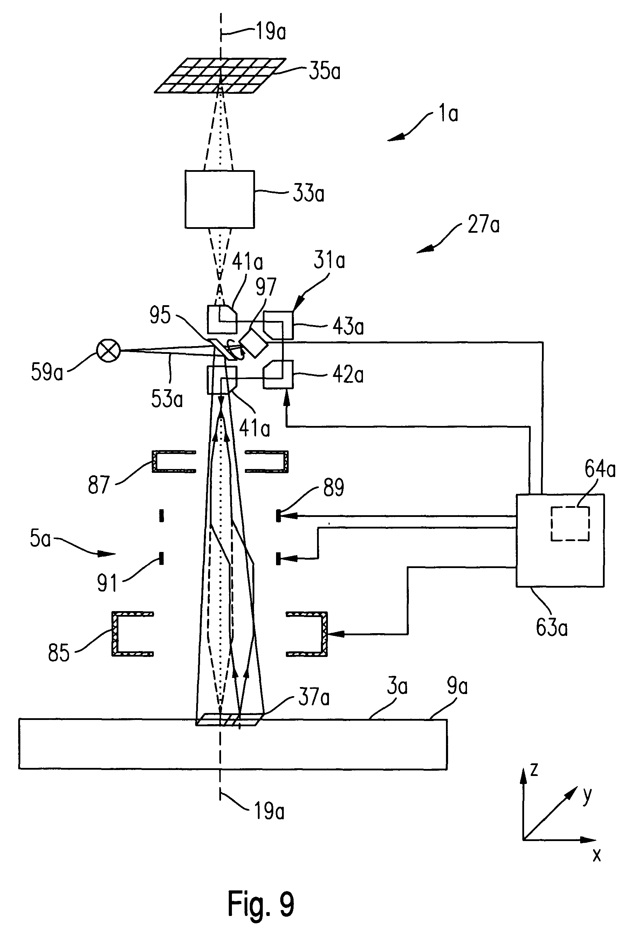

Gemäß einer weiteren Ausführungsform der Erfindung wird das in Figur 1 gezeigte Elektronenmikroskop 1 dazu eingesetzt, einen Halbleiterwafer 9 mit einer Halbleiterstruktur 3 zu untersuchen, welche einen ähnlichen Aufbau aufweist, wie er in Figur 2 gezeigt ist, wobei allerdings die Schicht 11 und die Schicht 13 aus verschiedenen Materialien gebildet sind, diese jedoch beide elektrisch im wesentlichen nicht-leitend sind. Beispielsweise besteht die Schicht 11 aus SiO₂ und die Schicht 13 aus Si₃N₄. Die beiden Materialien der Schichten 11 und 13 weisen Sekundärelektronenausbeutecharakteristika auf, wie sie in Figur 8 mit Kurven 65 bzw. 81 dargestellt sind. Beide Kurven 65 und 81 weisen erste und zweite Neutralpunkte und jeweils ein dazwischen liegendes Maximum auf, wobei in Figur 8 die Energien, die sich auf das die obenliegende Oberfläche bereitstellende Material beziehen, mit dem hochgestellten Buchstaben b bezeichnet sind und die Energien, die sich auf das den Boden 17 bereitstellende Material 13 beziehen, mit dem hochgestellten Buchstaben a bezeichnet sind. Die beiden Kurven 81 und 65 schneiden sich bei einer Energie Eₛ, welche in dem gezeigten Fall zwischen den beiden Maxima Eₘ^{a} und Eₘ^{b} liegt. Bei Energien, die größer sind als die Energie Eₛ liegt die Kurve 65 oberhalb der Kurve 81. Dies deutet darauf hin, daß sich das Material, welches die obenliegende Oberfläche bereitstellt und durch die Kurve 65 repräsentiert ist, stärker positiv auflädt als das Material, welches den Boden bereitstellt und durch die Kurve 81 repräsentiert ist. Entsprechend wird auch bei dieser Materialkombination eine bezüglich der obenliegenden Oberfläche negative Aufladung des Bodens der Ausnehmung erreicht, wobei auch hier innerhalb der Ausnehmung ein die Sekundärelektronen beschleunigendes elektrisches Feld entsteht. Entsprechend wird zur Beobachtung einer solchen Halbleiterstruktur die Energie der Primärelektronen über die Steuerung 63 und Elektronenquelle 55 derart eingestellt, daß deren Energie beim Auftreffen auf die Halbleiterstruktur oberhalb des Schnittpunkts der Kurven 65 und 81 bei der Energie Eₛ liegt. In der beschriebenen Ausführungsform wird die Energie Eₚ der Primärelektronen auf einen Wert zwischen dem Maximum Eₘ^{b} und dem zweiten Neutralpunkt der Kurve 65 an der Energie E₂^{b} eingestellt.

Nachfolgend werden weitere Varianten des im Zusammenhang mit den Figuren 1 bis 8 erläuterten Elektronenmikroskops beschrieben, welche ebenfalls zur Ausführung von Ausführungsformen des erfindungsgemäßen Verfahrens geeignet sind. Hierbei werden Komponenten, die hinsichtlich ihres Aufbaus und ihrer Funktion den in den Figuren 1 bis 8 dargestellten Komponenten entsprechen, mit den gleichen Bezugszeichen versehen, zur Unterscheidung jedoch mit einem zusätzlichen Buchstaben versehen. Hier wird auch auf die gesamte vorangehende Beschreibung Bezug genommen.

In der in Figur 8 dargestellten Situation liegen die Energien E₁^{b}, Eₘ^{b} und E₂^{b} der Sekundärelektronenausbeutecharakteristik 65 des Materials 11, welches die obenliegende Oberfläche 15 bereitstellt, oberhalb den entsprechenden Energien E₁^{a}, Eₘ^{a} bzw. E₂^{a} des die Oberfläche des Lochbodens 17 bereitstellenden Materials 13. Es ist jedoch auch möglich, daß die Energien des den Lochboden 17 bereitstellenden Materials größer sind als die entsprechenden Energien des die obenliegende Oberfläche bereitstellenden Materials. Es ist dann die kinetische Energie der Primärelektronen entsprechend anzupassen und insbesondere derart einzustellen, daß die Sekundärelektronenausbeute an dem die obenliegende Oberfläche 15 bereitstellenden Material 11 größer ist als die des den Lochboden 17 die Ausnehmung 7 bereitstellenden Materials 13.

Ein in Figur 9 gezeigtes Elektronenmikroskop 1a ist zur Ausführung des erfindungsgemäßen Verfahrens geeignet und wird dazu eingesetzt, eine Halbleiterstruktur 3a auf einem Wafer 9a abzubilden, wobei die Halbleiterstruktur ebenfalls Ausnehmungen mit einem hohen Aspektverhältnis aufweist, wie dies anhand der Figur 2 erläutert wurde.

Das Elektronenmikroskop 1a umfaßt eine Elektronenmikroskopieoptik 27a, welche dazu vorgesehen ist, einen Bereich 37a auf der Oberfläche des Wafers 9a auf einen ortsauflösenden Detektor 35a abzubilden. Die Mikroskopieoptik 27a weist eine optische Achse 19a auf, bezüglich der die Komponenten der Mikroskopieoptik 27a, welche im Strahlengang der Halbleiterstruktur 3 näher als der Energiefilter 31a liegen, im wesentlichen symmetrisch angeordnet sind. Im Unterschied zu dem in Figur 1 gezeigten Elektronenmikroskop ist bei dem in Figur 9 gezeigten Elektronenmikroskop 1a allerdings der auf den Detektor 35a abgebildete Bereich 37a der Waferoberfläche bezüglich der optischen Achse 19 verlagerbar. Hierzu umfaßt die Elektronenmikroskopieoptik 27a eine Objektivanordnung 5a aus zwei Fokussierlinsen 85 und 87, welche zusammen als Linsenduplett wirken und wobei die Fokussierlinse 85 die dem Wafer 9a nächstliegende Fokussierlinse des Dupletts ist. In dem Bereich 37a aus von dem Wafer austretende Sekundärelektronen durchlaufen somit die Fokussierlinse 85, sodann die Fokussierlinse 87, dann weiter einen abbildungserhaltenden Energiefilter 31a, welcher ebenfalls von einer Steuerung 63a angesteuert wird, um einstellbare Energien von Sekundärelektronen zu selektieren, welche den Energiefilter 31a passieren. Die von dem Energiefilter 31a selektierten Sekundärelektronen durchlaufen eine nur schematisch dargestellte Nachvergrößerungsoptik 33a, bevor sie auf den Detektor 35a treffen, um dort ein elektronenmikroskopisches Abbild des Bereichs 37a des Wafers 9a entstehen zu lassen.

Zwischen den beiden Fokussierlinsen 85 und 87 der Objektivanordnung 5a sind zwei Deflektoren 89 und 91 im Strahlengang hintereinander angeordnet, welche jeweils Elektronen um einander entgegengesetzt gleiche Winkel ablenken, so daß die beiden Deflektoren 91 und 89 zusammen derart wirken, daß ein diese beiden Deflektoren 89, 91 durchsetzender Elektronenstrahl parallel um einen Betrag M quer zur optischen Achse 19a versetzt wird. Die beiden Deflektoren 89, 91 werden von der Steuerung 63a angesteuert, um den Ablenkwinkel eines jeden Deflektors einzustellen und somit auch den parallelen Strahlversatz des Elektronenstrahls zwischen Eintritt und Austritt in die beiden Deflektoren 89, 91 einzustellen. Der durch die beiden Deflektoren 89, 91 erzeugte Strahlversatz des Sekundärelektronenstrahls führt dazu, daß der auf den Detektor 35a abgebildete Bereich 37a des Wafers 9a in der Ebene der Waferoberfläche innerhalb baulich gegebener Grenzen verlagerbar ist und somit auswählbare Bereiche der Waferoberfläche auf den Detektor 35a abgebildet werden können.

Ein zur Auslösung der Sekundärelektronen aus der Waferoberfläche notwendiger Primärenergiestrahl ist bei dem Elektronenmikroskop 1a durch einen Photonenstrahl 53a bereitgestellt, welcher von einer geeigneten Lichtquelle 59a erzeugt wird und auf den auf den Detektor 35a abgebildeten Bereich 37a gerichtet ist. Hierbei erfolgt das Richten des Photonenstrahls 53a auf die Waferoberfläche über eine Reflexion an einem Spiegel 94, welcher über einen von der Steuerung 63a angesteuerten Antrieb 96 verschwenkbar ist, um den von dem Photonenstrahl 53a auf der Waferoberfläche beleuchteten Bereich an den auf den Detektor 35a abgebildeten und bezüglich der optischen Achse 19a verlagerbaren Bereich 37a mitzuführen, so daß nicht ein übermäßig großer Bereich auf der Waferoberfläche mit Primärenergie beleuchtet werden muß und entsprechend der Energieeintrag auf den Wafer reduziert ist.

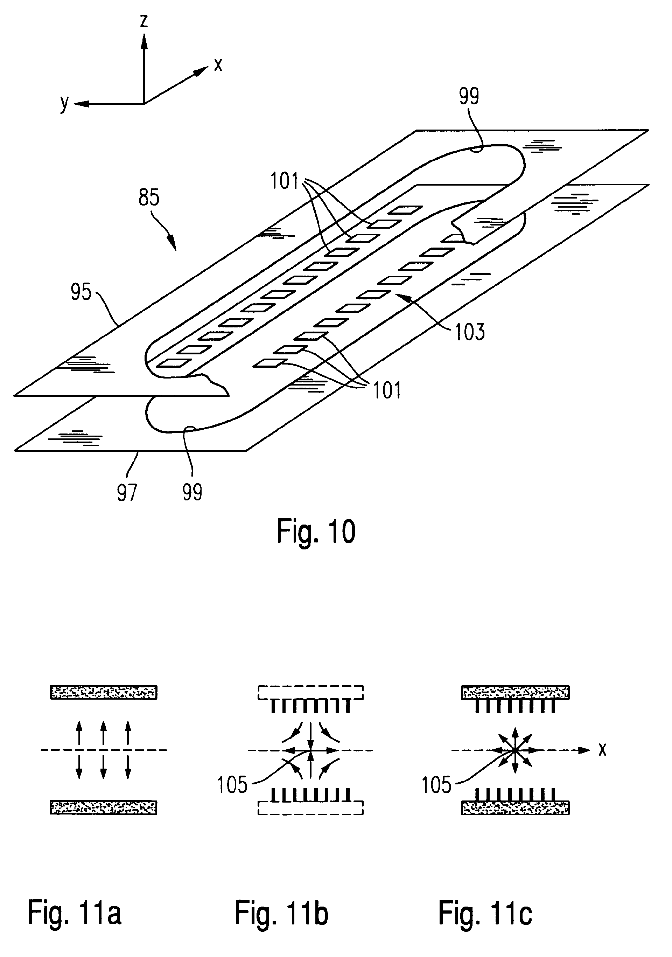

Die dem Wafer 9a nahe Fokussierlinse 85 ist in Figur 10 perspektivisch und schematisch dargestellt. Sie umfaßt zwei jeweils ebene Blendenelektroden 95 und 97, welche orthogonal zu der optischen Achse 19a orientiert und mit Abstand in Richtung der optischen Achse 19a voneinander angeordnet sind. Eine jede der Blendenelektroden 95, 97 weist einen in einer x-Richtung sich erstreckenden Schlitz 99 auf, durch den die Sekundärelektronen hindurch treten.

In Richtung der optischen Achse 19a zwischen den beiden Blendenelektroden 95, 97 sind zwei parallel und mit Abstand voneinander angeordnete Reihen von Fingerelektroden 101 vorgesehen, wobei sich die Reihen ebenfalls in x-Richtung erstrecken und die Sekundärelektronen zwischen den beiden Reihen hindurch treten. Die Gesamtheit der Fingerelektroden 101 bildet eine nachfolgend als Kammelektrode 103 bezeichnete Elektrodenanordnung. An jede der Fingerelektroden 101 und an die beiden Blendenelektroden 95 und 97 kann, gesteuert durch die Steuerung 63a, eine separat einstellbare Spannung angelegt werden. Hierbei bildet insbesondere die an die Blendenelektrode 97 angelegte Spannung bzw. das Potential der Blendenelektrode 97 relativ zu dem Wafer das zwischen der Objektivanordnung 5a und dem Wafer notwendige Zugfeld, um die Sekundärelektronen von dem Wafer weg zu beschleunigen.

Durch die Steuerung 63a wird an die Fingerelektroden 101 ein solches Spannungsmuster angelegt, daß das durch die Fingerelektroden 101 erzeugte elektrische Feld in etwa Quadrupolsymmetrie aufweist, wie dies in Figur 11b schematisch dargestellt ist. Durch entsprechende Ansteuerung der Fingerelektrode 101 kann durch die Steuerung 63a eine Symmetrieachse 105 des Quadrupolfeldes in x-Richtung verlagert werden.

Andererseits wirken die beiden Blendenelektroden 95, 97 jeweils auf die diese durchsetzenden Sekundärelektronen wie eine Zylinderlinse, wie dies in Figur 11A anschaulich schematisch dargestellt ist. Auf die die Fokussierlinse 85 durchsetzenden Sekundärelektronen wirkt somit eine Überlagerung des Zylinderlinsenfeldes gemäß Figur 11a, wie es durch die beiden Blendenelektroden 95, 97 bereitgestellt ist, und des Quadrupolfeldes gemäß Figur 11b, wie es durch die Kammelektroden 103 bereitgestellt ist. Diese Überlagerung der elektrischen Felder entspricht einem Rundlinsenfeld mit einer Symmetrieachse 105, wie dies in Figur 11c schematisch dargestellt ist.

Dies bedeutet, daß die Fokussierlinse 85 auf die diese durchsetzenden Sekundärelektronen eine Wirkung wie eine fokussierende Rundlinse hat, deren Symmetrieachse 105 durch die Steuerung 63a in x-Richtung verlagerbar ist.

Im Betrieb legt die Steuerung 63a an die Fingerelektroden 101 eine derartiges Spannungsmuster an, daß die Symmetrieachse 105 des Rundlinsenfeldes um den gleichen Betrag M von der Symmetrieachse 19a weg verlagert ist, wie dies dem durch die Deflektoren 89, 91 erzeugten Strahlversatz entspricht, um das auf dem Detektor 35a abgebildete Feld 37a auf der Waferoberfläche zu verlagern. Hierdurch ist die Wirkung der Fokussierlinse 85 auf die aus dem Bereich 37a austretenden Sekundärelektronen von der Auslenkung M im wesentlichen unabhängig. Hierdurch werden Abbildungsfehler, wie sie herkömmliche Rundlinsenfelder für entfernt von der Symmetrieachse des Rundlinsenfeldes verlaufende Strahlengänge erzeugen, weitgehend vermieden.

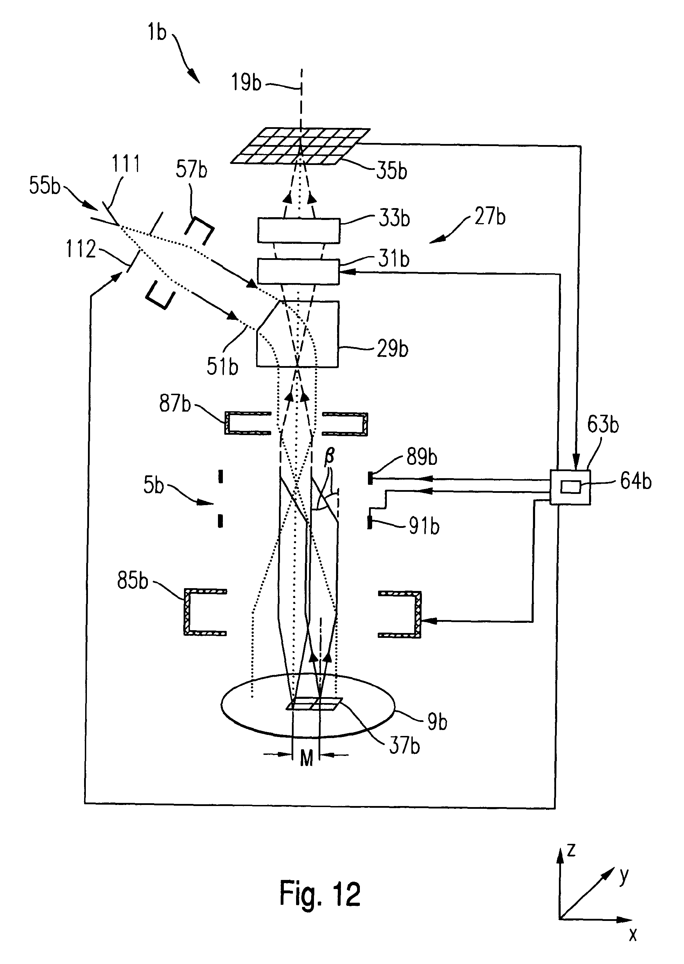

In Figur 12 ist ein zur Ausführung des erfindungsgemäßen Verfahrens geeignetes Elektronenmikroskop 1b schematisch dargestellt, welches einen ähnlichen Aufbau aufweist wie das im Zusammenhang mit den Figuren 9 bis 11 erläuterte Elektronenmikroskop.

Im Unterschied zu dem anhand der Figuren 9 bis 11 erläuterten Elektronenmikroskop erfolgt bei dem in Figur 12 gezeigten Elektronenmikroskop 1b die Beleuchtung eines auf einem Detektor 35b abgebildeten Bereich 37b eines Wafers 9b nicht mit einem Photonenstrahl sondern mit einem Primärelektronenstrahl 51b.

Eine Elektronenmikroskopieoptik 27b zur Abbildung des Bereichs 37b des Wafers 9b auf den Detektor 35b umfaßt wiederum eine Objektivanordnung 5b mit einem Fokussierlinsenduplett aus Fokussierlinsen 85b und 87b und einem dazwischenliegenden Deflektorpaar aus Deflektoren 89b und 91b, welche einen Strahlversatz für den das Linsenduplett 85b, 87b durchsetzenden Sekundärelektronenstrahl durch zwei hintereinander erfolgende Ablenkungen um jeweils einen Winkel β erzeugen.

Die dem Wafer 9b nächstliegende Fokussierlinse 85b des Linsendupletts umfaßt wiederum eine Anordnung von Blendenelektroden und Kammelektroden, wie dies anhand der Figuren 10 und 11 erläutert wurde.

Die Elektronenquelle 55b umfaßt eine Glühkathode 111 und eine Anode 112, wobei eine Spannung zwischen der Kathode 111 und der Anode 112 durch die Steuerung 63a einstellbar ist, um die kinetische Energie der Elektronen eines Primärelektronenstrahls 51b einzustellen. Der Primärelektronenstrahl 51b wird durch eine Magnetlinse 57b kollimiert und tritt in einen Strahlablenker 29b ein, welcher beispielsweise quer zueinander orientierte elektrische und magnetische Felder bereitstellt (Wien-Filter), so daß er schließlich entlang der optischen Achse 19b hin zu dem Wafer 9b verläuft. Auch auf den Primärelektronenstrahl 51b wirken die Fokussierlinsen 87b, 85b und die Deflektoren 89b und 91b. Dabei entspricht die Wirkung auf den Primärelektronenstrahl nicht exakt der Wirkung, die die Komponenten 87b, 85b, 89b und 91b auf den Sekundärelektronenstrahl haben. Allerdings wird durch Ansteuerung der Deflektoren 89b und 91b und der Kammelektroden der Fokussierlinse 85b der Bereich, in dem der Primärelektronenstrahl 51b auf den Wafer trifft, relativ zu der optischen Achse 19b verlagert. Hierbei ist, anders als für den die elektronenoptische Abbildung des Bereichs 37b auf den Detektor 35b bewerkstelligenden Sekundärelektronenstrahl, eine erhöhte Anforderung an die Präzision der Wirkung der angesteuerten Komponenten 89b, 91b und 85b nicht gegeben, da der Primärelektronenstrahl lediglich zur Beleuchtung des Bereichs 37b dient.

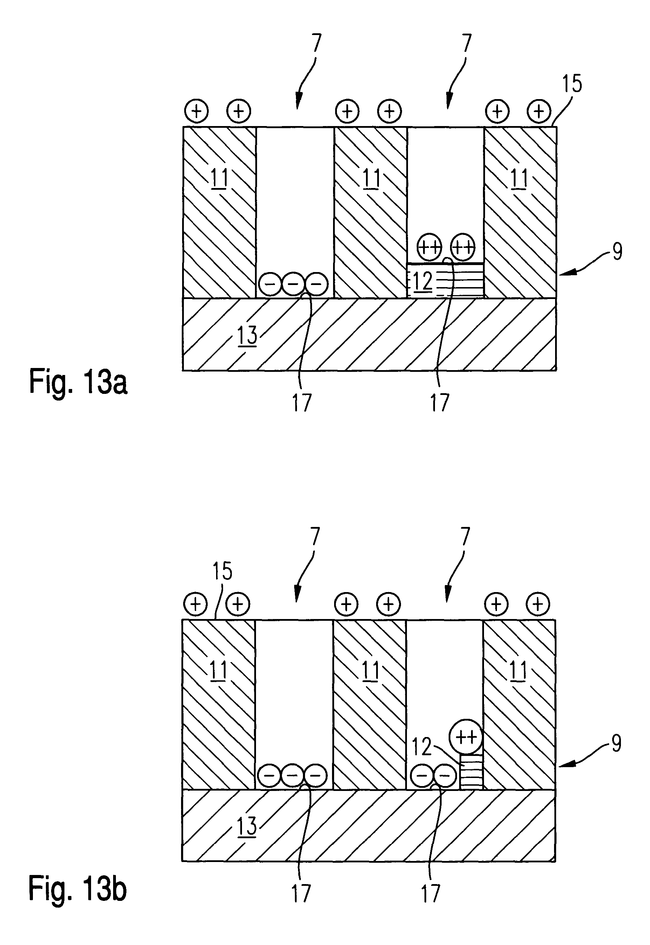

Die vorangehend anhand der Figuren 1 bis 12 beschriebenen Verfahren und Elektronenmikroskope werden nun dazu eingesetzt, Defekte bei der Fertigung von Strukturen mit hohem Aspektverhältnis aufzufinden. Die Figuren 13a und 13b stellen Beispiele für derartige Defekte dar. In diesen ist jeweils links eine Ausnehmung 7 in einem Material 11 dargestellt, welche defektfrei gefertigt ist, wobei der Boden der Ausnehmung 7 vollständig durch ein Material 13 gebildet ist. Rechts in den Figuren 13a und 13b ist jeweils eine Ausnehmung 7 symbolisch dargestellt, welche einen Fertigungsdefekt aufweist. In Figur 13a ist der Boden der Ausnehmung 7 vollständig durch ein von den Materialien 11 und 13 verschiedenes Defektmaterial 12 bereitgestellt, und in Figur 13b ist der Boden der Ausnehmung lediglich teilweise von einem von den Materialien 11 und 13 verschiedenen Defektmaterial 12 bereitgestellt.

In den Figuren 13a und 13b ist eine relative Aufladungssituation mit den Symbolen "-", "+" und "++" gekennzeichnet. Diese wird dadurch erzeugt, daß die Energie der Primärelektronen derart eingestellt ist, daß sich das obenliegende Material 11 relativ zu dem Material 13 des defektfreien Bodens der Ausnehmung 7 positiv auflädt und sich ferner das Defektmaterial 12 positiv relativ zu dem die obenliegende Oberfläche bereitstellenden Material 11 auflädt.

In der in der Figur 13b rechts dargestellten Situation ist ersichtlich, daß die positive Aufladung des Defektmaterials 12 einen Einfluß auf den Potentialverlauf innerhalb der Ausnehmung 7 derart hat, daß ein Sekundärelektronen aus der Ausnehmung herausbeschleunigendes elektrisches Feld reduziert ist. Entsprechend verlassen Sekundärelektronen vom Boden 17 der Ausnehmung diese mit einer geringeren kinetischen Energie als dies bei der defektfreien Ausnehmung 7 links in Figur 13b der Fall ist.

Wenn in Figur 4 die Kurve 69 die Energieverteilung der Sekundärelektronen vom Boden der defektfreien Ausnehmung 7 wiedergibt, so ist in Figur 4 eine vorteilhafte Wahl des Energiefensters mit den Energien Eₘᵢₙ und Eₘₐₓ angegeben.

In Figur 4 ist ferner mit gestrichelter Linie eine Kurve 69' eingetragen, welche die Energieverteilung der Sekundärelektronen vom Boden der defektbehafteten Ausnehmung der Figur 13b repräsentiert. Aufgrund des geringeren beschleunigenden Feldes innerhalb der Ausnehmung 7 ist die Kurve 69' relativ zu der Kurve 69 zu niedrigen Energien hin verschoben. Bei der eingetragenen Wahl des Energiefensters (Eₘᵢₙ, Eₘₐₓ) führt das Defektmaterial 12 in der Ausnehmung somit zu einer Reduzierung der Sekundärelektronenintensität innerhalb des Energiefensters (Eₘᵢₙ, Eₘₐₓ), so daß defektfreie Ausnehmungen von defektbehafteten Ausnehmungen gemäß Figur 13b, das heißt mit einer teilweisen Bedeckung des Bodens 17 der Ausnehmung mit einem Defektmaterial, unterschiedenen werden können.

In der in Figur 13a dargestellten Situation ist der Boden 17 der Ausnehmung positiv relativ zu der obenliegenden Oberfläche 15 aufgeladen, und es entsteht innerhalb der Ausnehmung 7 ein elektrisches Feld, welches Sekundärelektronen am Verlassen der Ausnehmung 7 hindert. Entsprechend verlassen nur wenige Sekundärelektronen die Ausnehmung.

Ist das Material 13 des Bodens ein elektrisch leitfähiges Material und sind das Material 11 der obenliegenden Oberfläche und das Defektmaterial 12 jeweils Nichtleiter, so ist es vorteilhaft, die kinetische Energie der Primärelektronen derart einzustellen, daß die Sekundärelektronenausbeute des Materials 11 größer ist als 1 und zudem die Sekundärelektronenausbeute des Defektmaterials 12 größer oder gleich der Sekundärelektronenausbeute des Materials 11 ist.

Ferner ist es hierbei ebenfalls vorteilhaft, die kinetische Energie der Primärelektronen so einzustellen, daß die Sekundärelektronenausbeute des Materials 11 kleiner ist als 1 und zudem die Sekundärelektronenausbeute des Defektmaterials 12 kleiner oder gleich der Ausbeute des Materials 11 ist.

Ist das den Boden 17 bereitstellende Material 13 ferner ein Nichtleiter, so ist es vorteilhaft, die kinetische Energie der Primärelektronen derart einzustellen, daß die Sekundärelektronenausbeute des Materials 11 größer ist als die des Materials 13 und ferner die Sekundärelektronenausbeute des Materials 12 größer oder gleich der des Materials 11 ist.

Ferner ist es hierbei ebenfalls vorteilhaft, die kinetische Energie der Primärelektronen derart einzustellen, daß die Sekundärelektronenausbeute des Materials 11 kleiner ist als die Sekundärelektronenausbeute des Materials 13 und zudem die Sekundärelektronenausbeute des Defektmaterials 12 kleiner oder gleich ist als die Sekundärelektronenausbeute des Materials 11.

Sämtliche vorangehend genannten Einstellungen und die zugehörigen Einstellungen des Energiefensters des Energiefilters sowie der übrigen Komponenten des Elektronenmikroskops werden vorteilhafterweise in dem Speicher 64 der Steuerung 63 bereitgehalten, um schnell zwischen den verschiedenen Betriebsmoden des Elektronenmikroskops umzuschalten und entsprechend aussagekräftige Abbildungen der untersuchten Halbleiteranordnung zu gewinnen, wobei aus verschiedenen Abbildungen jeweils verschiedene Defekttypen der Ausnehmungen bzw. defektfreie Ausnehmungen leicht ermittelbar sind.

In den vorangehend beschriebenen Elektronenmikroskopen der Figuren 1, 9 und 12 wurden zur Bereitstellung des Primärenergiestrahls Elektronenstrahlen und Photonenstrahlen verwendet. Es ist jedoch auch möglich, hierzu Ionenstrahlen zu verwenden. Insbesondere ist es dabei möglich, einen Ionenstrahl zur Erzeugung der Sekundärelektronen einzusetzen, welcher weiterhin in einem anderen Betriebsmodus des Elektronenmikroskops, zur Bearbeitung des Halbleitermaterials, wie etwa zur Erzeugung von Einschnitten darin, eingesetzt wird.

Der im Zusammenhang mit der Figur 5 beschriebene abbildungserhaltene Energiefilter weist aufgrund seines Strahlverlaufs einen sog. Aufbau vom Ω-Typ auf, es ist jedoch ebenfalls möglich, Alternativarten von Energiefiltern einzusetzen. Ein Beispiel hierfür ist ein Energiefilter, wie er in der Fachwelt als α-Typ bezeichnet wird.

Bei den anhand der Figuren 9 und 12 beschriebenen Elektronenmikroskopen umfaßt die dem Wafer am nächsten angeordnete Fokussierlinse eine Kammlinse, wie dies zusammen mit den Figuren 10 und 11 erläutert wurde. Diese Fokussierlinse ist in der Lage, die Symmetrieachse ihrer Fokussierlinsenwirkung in eine x-Richtung quer zur Waferoberfläche zu verlagern. Es ist hier jedoch auch möglich, diese Funktion durch einen anderen Linsentyp zu erreichen. Ein Beispiel hierfür ist eine magnetische Fokussierlinse, wie sie in dem Artikel "MOL ("Moving objective lens")", Optic 48 (1997), Seiten 255ff. von E. Goto et al. oder in US 4,376,249 beschrieben ist. Eine bevorzugte Ausgestaltung einer solchen magnetischen Fokussierlinse mit variabler Achse ist in der Patentanmeldung DE 100 44 199.8 beschrieben und wird durch Inbezugnahme ebenfalls in die folgende Anmeldung vollumfänglich aufgenommen.

## Patentansprüche

1. Verfahren zum elektronenmikroskopischen Beobachten einer Halbleiteranordnung (3), umfassend:
Bereitstellen einer Elektronenmikroskopieoptik (27) zum Abbilden von Sekundärelektronen, welche aus der Halbleiteranordnung (3) innerhalb eines ausgedehnten Objektfeldes (37) austreten, auf einen ortsauflösenden Detektor (35),
Bereitstellen einer Beleuchtungseinrichtung (55, 59) zur Emission eines Primärenergiestrahls (51, 53),
Richten des Primärenergiestrahls (51, 53) auf wenigstens das Objektfeld (37), um dort aus der Halbleiteranordnung (3) Sekundärelektronen auszulösen,
**dadurch gekennzeichnet, daß** die Halbleiteranordnung (3) einen Bereich mit einer von einem ersten Material (11) bereitgestellten obenliegenden Oberfläche (15) und einer von der obenliegenden Oberfläche (15) umgebenen Ausnehmung (7) mit hohem Aspekt-Verhältnis aufweist, welche einen Boden (17) aufweist, der von einem zweiten Material (13) bereitgestellt ist.

2. Verfahren nach Anspruch 1, wobei die Beleuchtungseinrichtung eine Elektronenquelle (55) umfaßt und der Primärenergiestrahl einen Primärelektronenstrahl (51) mit einer einstellbaren kinetischen Energie von Elektronen des Primärelektronenstrahls (51) umfaßt.

3. Verfahren nach Anspruch 2, wobei das erste und das zweite Material (11, 13) voneinander verschieden sind und wobei die kinetische Energie der Elektronen des Primärelektronenstrahls (51) derart eingestellt wird, daß sich die obenliegende Oberfläche (15) relativ zu dem Boden (17) positiv auflädt.

4. Verfahren nach Anspruch 3, wobei wenigstens das erste Material (11) elektrisch im wesentlichen nichtleitend ist.

5. Verfahren nach Anspruch 3 oder 4, wobei das erste Material (11) eine Sekundärelektronenausbeutecharakteristik (65) in Abhängigkeit von der Energie der Elektronen des Primärelektronenstrahls (51) mit einem Maximum (Eₘ) und einem ersten Neutralpunkt (E₁) unterhalb des Maximums (Eₘ) und einem zweiten Neutralpunkt (E₂) oberhalb des Maximums (Eₘ) aufweist.

6. Verfahren nach Anspruch 5, wobei die kinetische Energie der Elektronen des Primärelektronenstrahls (51) auf einen Energiewert (Eₚ) eingestellt wird, der größer ist als eine Energie des ersten Neutralpunkts (E₁) der Sekundärelektronenausbeutecharakteristik (65) des ersten Materials (11).

7. Verfahren nach Anspruch 5 oder 6, wobei das zweite Material (13) elektrisch im wesentlichen leitend ist und wobei die kinetische Energie der Elektronen des Primärelektronenstrahls (51) auf einen Energiewert (Eₚ) eingestellt wird, der kleiner ist als eine Energie des zweiten Neutralpunkts (E₂) des ersten Materials (11).

8. Verfahren nach Anspruch 5, wobei das zweite Material (13) elektrisch im wesentlichen nicht leitend ist und eine Sekundärelektronenausbeutecharakteristik (81) in Abhängigkeit von der Energie der Elektronen des Primärelektronenstrahls (51) mit einem Maximum (Eₘ^{a}) und einem ersten Neutralpunkt (E₁^{a}) unterhalb des Maximums (Eₘ^{a}) und einem zweiten Neutralpunkt (E₂^{a}) oberhalb des Maximums (Eₘ^{a}) aufweist, und wobei die kinetische Energie der Elektronen des Primärelektronenstrahls (51) auf einen Energiewert (Eₚ) aus einem Energiebereich eingestellt wird, in dem die Sekundärelektronenausbeutecharakteristik (65) des ersten Materials (11) größer ist als die Sekundärelektronenausbeutecharakteristik (81) des zweiten Materials (13).

9. Verfahren nach einem der Ansprüche 1 bis 8, wobei die Beleuchtungseinrichtung eine Photonenquelle (59) umfaßt und der Primärenergiestrahl einen Photonenstrahl (53) umfaßt.

10. Verfahren nach Anspruch 9, wobei der Photonenstrahl (53a) im wesentlichen orthogonal zu der obenliegenden Oberfläche (15) auf die Halbleiteranordnung (3a) aufgestrahlt wird.

11. Verfahren nach Anspruch 9, wobei der Photonenstrahl (53) unter einem Winkel zwischen 10° bis 80° auf die obenliegende Oberfläche (15) auf die Halbleiteranordnung (3) aufgestrahlt wird.

12. Verfahren nach einem der Ansprüche 1 bis 11, wobei die Elektronenmikroskopieoptik (27a; 27b) dazu ausgebildet ist, das Objektfeld, das auf den Detektor (35a; 35b) abgebildet wird, relativ zu dem Detektor (35a; 35b) in einer Ebene der obenliegenden Oberfläche zu verlagern.

13. Verfahren nach Anspruch 12, wobei der Primärenergiestrahl (53a; 51b) änderbar auf die Halbleiteranordnung gerichtet wird, um im wesentlichen nur das Objektfeld (37a; 37b) zu beleuchten.

14. Verfahren nach einem der Ansprüche 1 bis-13, wobei die Elektronenmikroskopieoptik (27) einen abbildungserhaltenden Energiefilter (31) umfaßt, der Sekundärelektronen mit einer kinetischen Energie, die kleiner ist als eine einstellbare erste Schwellenenergie, ausblendet.

15. Verfahren nach Anspruch 14, wobei die erste Schwellenenergie derart eingestellt wird, daß von der positiv aufgeladenen obenliegenden Oberfläche (15) ausgelöste Elektronen im wesentlichen nicht auf den Detektor (35) abgebildet werden.

16. Verfahren nach Anspruch 15, wobei der Energiefilter (31) ferner Sekundärelektronen mit einer kinetischen Energie, die größer ist als eine einstellbare zweite Schwellenenergie, ausblendet.

17. Verfahren nach einem der Ansprüche 1 bis 16, wobei das Aspekt-Verhältnis größer als 1,5, vorzugsweise größer als 4, weiter bevorzugt größer als 10 ist, und noch weiter bevorzugt größer als 15 ist.

18. Elektronenmikroskopiesystem, insbesondere zum Erfassen von Defekten an einer Halbleiteranordnung (3), welche einen Bereich mit einer von einem ersten Material (11) bereitgestellten obenliegenden Oberfläche (15) und einer von der obenliegenden Oberfläche (15) umgebenen Ausnehmung (7) mit hohem Aspekt-Verhältnis aufweist, wobei die Ausnehmung (7) einen Boden (17) aufweist, der von einem zweiten Material (13) bereitgestellt ist, und wobei das Elektronenmikroskopiesystem umfaßt:
eine Elektronenmikroskopieoptik (27) zum Abbilden von Sekundärelektronen, welche aus einem Objekt (3) innerhalb eines ausgedehnten Objektfeldes (37) austreten, auf einen ortsauflösenden Detektor (35),
eine Beleuchtungseinrichtung (55, 59) zum Richten eines Primärenergiestrahls (51, 53) auf wenigstens das Objektfeld (37), um dort aus der Halbleiteranordnung (3) Sekundärelektronen auszulösen,
wobei die Elektronenmikroskopieoptik (27) einen abbildungserhaltenden Energiefilter (31) mit einem einstellbaren Energiefenster derart umfaßt, daß Sekundärelektronen, deren kinetische Energien außerhalb des Energiefensters (Eₘᵢₙ, Eₘₐₓ) liegen, im wesentlichen nicht auf den ortsauflösenden Detektor (35) abgebildet werden, und
wobei das Elektronenmikroskopiesystem ferner eine Steuerung (63) zum Einstellen des Energiefensters des Energiefilters (31) umfaßt und wobei die Steuerung (63) einen Speicher (64) aufweist, um wenigstens eine Einstellung für das Energiefenster zu speichern,
wobei die Beleuchtungseinrichtung (55) als Primärenergiestrahl einen Elektronenstrahl (51) einstellbarer kinetischer Energie erzeugt und wobei der Speicher (64) dazu vorgesehen ist, zu Einstellungen des Energiefensters eine Einstellung der kinetischen Energie des Elektronenstrahls (51) zu speichern.

19. Elektronenmikroskopiesystem, insbesondere nach Anspruch 18, umfassend:
eine Elektronenmikroskopieoptik (27) zum Abbilden von Sekundärelektronen, welche innerhalb eines ausgedehnten Objektfeldes (37) aus einem Bereich um eine Objektebene des Elektronenmikroskopiesystems ausgehen, auf einen ortsauflösenden Detektor (35),
eine Beleuchtungseinrichtung (55, 59) zum Richten eines Primärenergiestrahls (51, 53) auf wenigstens das Objektfeld (37), um dort aus einem Objekt (3) Sekundärelektronen auszulösen,
wobei die Elektronenmikroskopieoptik (27) einen abbildungserhaltenden Energiefilter (31) mit einem einstellbaren Energiefenster derart umfaßt, daß Sekundärelektronen, deren kinetische Energien außerhalb des Energiefensters (Eₘᵢₙ, Eₘₐₓ) liegen, im wesentlichen nicht auf den ortsauflösenden Detektor (35) abgebildet werden, und
wobei das Elektronenmikroskopiesystem ferner eine Steuerung (63) zum Einstellen des Energiefensters des Energiefilters (31) umfaßt und wobei die Steuerung (63) einen Speicher (64) aufweist, um wenigstens eine Einstellung für das Energiefenster zu speichern,
und wobei der Speicher (64) ferner dazu vorgesehen ist, zu einer jeden Einstellung des Energiefensters eine Einstellung einer Fokussierung der Elektronenmikroskopieoptik (37) zu speichern.

20. Elektronenmikroskopiesystem nach Anspruch 18 oder 19, wobei die Elektronenmikroskopieoptik (37) eine Blendenelektrode (23) zur Bereitstellung eines einstellbaren Extraktionsfeldes für Sekundärelektronen zwischen dem Objekt und der Blendenelektrode umfaßt, und wobei eine Speicherung der Einstellung des Energiefensters eine Speicherung einer Einstellung des Extraktionsfeldes umfaßt.
